# EUROPEAN PATENT SPECIFICATION

(11) **EP 3 106 948 B1**
(45) Date of publication and mention of the grant of the patent: **02.09.2020**
(21) Application number: 15746444.7
(22) Date of filing: 06.02.2015
(51) Int. Cl.: G05B 19/418, G05B 23/02, H05K 13/08

(54) **QUALITY CONTROL APPARATUS AND CONTROL METHOD**
VORRICHTUNG UND VERFAHREN ZUR QUALITÄTSKONTROLLE
APPAREIL ET PROCÉDÉ DE CONTRÔLE DE LA QUALITÉ

(30) Priority: 10.02.2014 JP 2014023318
(43) Date of publication of application: 21.12.2016
(73) Proprietor: Omron Corporation, Kyoto-shi, Kyoto 600-8530 (JP)
(72) Inventor: TANAKA Mayuko, Kyoto-shi Kyoto 600-8530 (JP); MORI Hiroyuki, Kyoto-shi Kyoto 600-8530 (JP)
(74) Representative: Kilian Kilian & Partner
(86) International application number: PCT/JP2015/053339
(87) International publication number: WO 2015/119232

(56) References cited:
- WO-A1-2011/155012
- JP-A- H06 112 295
- JP-A- 2007 079 933
- JP-A- 2008 108 815
- JP-A- 2009 140 044
- JP-A- 2010 191 744

## Description

### FIELD

The present invention relates to a technique for controlling the quality of a production line.

### BACKGROUND

An automated and labor-saving production line includes an inspection apparatus installed at an intermediate process or a final process of the line to automatically detect defects or sort out defective articles. An attempt has also been made to determine the cause of defects based on inspection results from the inspection apparatus, and use the information in the quality control or maintenance of the production facilities.

In this type of quality control system, determination criteria for inspection or control criteria for quality control set inappropriately can lower the efficiency of the production line. For example, too loose criteria increase the number of defective articles and increase the load of visual inspections as well as the cost for disposal of defective articles, whereas too strict criteria cause excessive checks and can unnecessarily reject acceptable articles or erroneously detect abnormalities or malfunctions in the production facilities and unnecessarily stop the line.

As a technique known in the art to overcome such difficulties, Patent Literature 1 describes a method for adjusting the determination criteria for inspection items (the area and the volume of solder) used in a printed solder inspection apparatus in a surface mounting line for printed circuit boards based on the quality determination results generated in postreflow inspections.

### CITATION LIST

### PATENT LITERATURE

Patent Literature 1: Japanese Unexamined Patent Application Publication No. 2007-43009
PTL 2: JP H06 112295 A
PTL3: WO 2011/155012 A1

### SUMMARY

### TECHNICAL PROBLEM

With the above technique known in the art, the determination criteria for inspection items are adjusted in an intermediate process using inspection results generated in a subsequent process in the line. This technique is expected to detect an event (a defect sign) in an intermediate process that can develop into a defect in a subsequent process. However, this technique can often cause excessive checks in the intermediate process. A mechanism for causing defects is not simple. Some defects can be caused by another process. Other defects can occur due to a combination of multiple factors. Thus, the final quality of the product may not be predictable simply by using the state of the product in an intermediate process. For a surface mounting line, an article with solder having an area or a volume deviating from normal values may be finally determined either acceptable or defective depending on the position of an electrode placed on the solder or its pushed-in amount, or the reflow conditions. The technique known in the art can excessively detect abnormalities in a solder printing apparatus, and can lower the efficiency of the production line.

In response to this issue, one or more aspects of the present invention are directed to a technique for reducing erroneous reports of abnormalities in production facilities in the quality control of the production line.

### SOLUTION TO PROBLEM

The invention is defined by the features of claim 1. Further embodiments are defined in the dependent claims. The structure according to one or more aspects of the present invention determines, for a product determined to be a defective article, that a production facility has an abnormality when an index (product state value) indicating the state of the defective article and an index (facility state value) indicating the state of the production facility observed in processing the defective product both deviate from normal state values.

More specifically, one aspect of the preset invention provides a quality control apparatus for quality control of a production line including one or more production facilities. The quality control apparatus includes a facility information obtaining unit, a product information obtaining unit, a storage unit, a determination unit, and an abnormality detection unit. The facility information obtaining unit obtains data about a facility state value indicating a state of a production facility observed when the production facility processes a product. The product information obtaining unit obtains data about a product state value indicating a state of the product measured from the product processed by the production facility. The storage unit stores a data group of facility state values of a plurality of acceptable articles produced previously and a data group of product state values of the plurality of acceptable articles. The determination unit determines, for a product determined to be a defective article, whether a product state value of the defective article is an abnormal value by comparing the product state value with an acceptable article distribution of product state values including the data group of product state values of the plurality of acceptable articles accumulated in the storage unit, and determines whether a facility state value observed when the defective article is processed is an abnormal value by comparing the facility state value with an acceptable article distribution of facility state values including the data group of facility state values of the plurality of acceptable articles accumulated in the storage unit. The abnormality detection unit determines that the production facility has an abnormality when the product state value and the facility state value of the defective article are both determined to be abnormal values.

This structure determines that a production facility has an abnormality when a product is determined to be a defective article, the product state value of the defective article is an abnormal value in comparison with an acceptable article distribution of product state values, and the facility state value of the production facility obtained in processing the defective article is an abnormal value in comparison with an acceptable article distribution of facility state values. This structure detects a state that can affect the final quality of the product and has its product state and production facility state both deviating from normal states. This reduces erroneous reports of abnormalities of the production facilities (excessive quality control).

The quality control apparatus according to the above aspect further includes an update unit that adds, for a product determined to be an acceptable article, a product state value of the product to the data group of product state values accumulated in the storage unit. When the determination unit determines, for a product determined to be a defective article, that a product state value of the defective article is not an abnormal value, the update unit deletes a part of the data group of product state values stored in the storage unit to increase a likelihood of the product state value of the defective article being determined to be an abnormal value. The acceptable article distribution of product state values corresponds to the probability distribution indicating the probability of each product state value being determined to indicate an acceptable article. The acceptable article distribution is updated (by learning) using information about an acceptable article and a defective article obtained during actual operation of the production line as described above. This increases the reliability of the acceptable article distribution and thus enhances the validity and the accuracy of the abnormality determination.

When the abnormality detection unit determines that the production facility has an abnormality, the abnormality detection unit outputs abnormality information, automatically changes an operating condition of the production facility, or changes the operating condition of the production facility after receiving permission to change the operating condition of the production facility from a user. The abnormality information includes at least any of information identifying the production facility determined to have an abnormality, the facility state value determined to be an abnormal value, information identifying the product determined to be a defective article, or the product state value determined to be an abnormal value. The abnormality information is output to inform the user of the need to change the conditions of the production facility or for maintenance of the production facility. The operating conditions of the production facility may be changed automatically or may be changed after permission to change the conditions is received from the user. This easily allows the quality of the production line to be maintained.

The determination unit determines whether a plurality of items of product state values measured from one product are abnormal values. The determination unit selects an item to be used for determination from the plurality of items. The product state values used for determination can be selected (limited) in accordance with the type of a product and its specifications. This reduces excessive quality control.

In some embodiments, the production line is a surface mounting line for a printed circuit board. The production facility includes at least one of a solder printing apparatus that prints solder paste on the printed circuit board, a mounter that mounts an electronic component onto the printed circuit board, or a reflow furnace that heats the solder paste. A state of the product is a shape of postreflow solder. In the surface mounting line, the cause for a defect is difficult to identify. Determining an abnormality in a production facility based on a determination result from a single process inspection, as with techniques known in the art, can cause excessive quality control.

In some embodiments, a determination result indicating whether solder is an acceptable article or a defective article is obtained from an X-ray inspection apparatus that inspects a state of a joint between the solder and an electrode of the electronic component with an X-ray image. This structure accurately detects the state of a joint between solder and an electrode that cannot be identified by appearance. This can minimize erroneous determination to be an acceptable article or a defective article, and reduce excessive quality control.

The aspects of the present invention provide a quality management apparatus including at least some of the components described above, or a method for controlling the quality control apparatus, a program enabling a computer to implement the processes included in the control method, or a computer-readable storage medium storing the program in a non-transitory manner. The processes and components described above may be combined freely when such combinations do not cause technical conflicts between them.

### ADVANTAGEOUS EFFECTS

The embodiments of the present invention reduce erroneous reports of abnormalities of production facilities in the quality control of the production line.

### BRIEF DESCRIPTION OF THE DRAWINGS

Fig. 1 shows the configuration of production facilities and a quality control system for a surface mounting line.
Figs. 2A to 2D show facility state value data and production data in one example.
Figs. 3A to 3D show the names of solder portions and product state values indicating the shape of the solder in one example.
Fig. 4 shows product state value data in one example.
Figs. 5A to 5D show example user interfaces for selecting product state values to be measured.
Figs. 6A and 6B are diagrams describing a change in the shape of the solder caused by a positional deviation of a component and difficulties in an appearance inspection.
Fig. 7 is a functional block diagram of an analyzer.
Fig. 8 is a flowchart showing an abnormality detection process performed by the analyzer.
Fig. 9 shows inspection result data in one example.
Figs. 10A and 10B are graphs each showing the distribution of acceptable articles.
Fig. 11 is a diagram describing example cases of the abnormality detection process.

### DETAILED DESCRIPTION

Embodiments of the present invention will now be described in detail by way of example with reference to the accompanying drawings. Unless otherwise specified, the dimensions, materials, shapes, and relative positions of components described in the embodiments should not be construed as limiting the scope of the invention.

### System Configuration

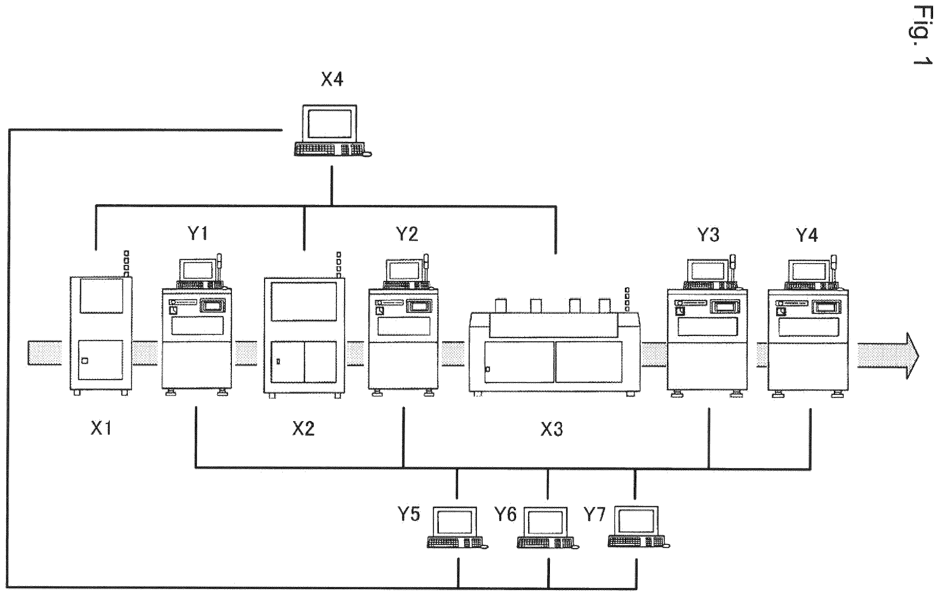

Fig. 1 schematically shows the configuration of production facilities and a quality control system used in a surface mounting line for printed circuit boards in one embodiment. Surface-mount technology (SMT) is a method for soldering an electronic component onto the surface of a printed circuit board. The surface mounting line includes three main processes: solder printing, component mounting, and reflow (solder melting).

As shown in Fig. 1, the surface mounting line includes production facilities including a solder printing apparatus X1, a mounter X2, and a reflow furnace X3 installed in this order from upstream. The solder printing apparatus X1 prints pasty solder onto electrode areas (lands) on a printed circuit board by screen printing. The mounter X2, which is also called a chip mounter, picks up an electronic component to be mounted on the circuit board, and places the component in the corresponding solder paste area. The reflow furnace X3, which is a heater, heats the workpiece to melt the solder paste and then cools it to solder the electronic component onto the circuit board. These production facilities X1 to X3 are connected to a production facility management apparatus X4 via a network (LAN). The production facility management apparatus X4 is a system responsible for the management and centralized control of the production facilities X1 to X3. The production facility management apparatus X4 stores, manages, and outputs a mounting program (including an operational procedure, manufacturing conditions, and setting parameters) defining the operation of each production facility, log data for each production facility, and other data. When receiving an instruction to change a mounting program from an operator or another apparatus, the production facility management apparatus X4 updates the mounting program installed in the corresponding production facility.

The surface mounting line also includes the quality control system Y for inspecting the state of the circuit board at the end of each process of solder printing, component mounting, and reflow, and automatically detects a defective or a suspected defective article. In addition to such automated sorting of acceptable articles and defective articles, the quality control system Y provides inspection results and their analysis results as feedback to the operations of the production facilities (by, for example, changing the mounting program). As shown in Fig. 1, the quality control system Y of the present embodiment includes four inspection apparatuses: a solder printing inspection apparatus Y1, a component inspection apparatus Y2, an appearance inspection apparatus Y3, and an X-ray inspection apparatus Y4. The quality control system Y also includes an inspection management apparatus Y5, an analyzer Y6, and a workstation Y7.

The solder printing inspection apparatus Y1 inspects the state of the printed solder paste on the circuit board fed from the solder printing apparatus X1. The solder printing inspection apparatus Y1 measures the solder paste printed on the circuit board in a two-dimensional or three-dimensional manner, and determines whether various inspection items for the solder paste fall within the range of normal values (tolerances) based on the measurement results. The inspection items include the volume, area, height, positional deviation, and shape of the solder. The solder paste is two-dimensionally measured with, for example, an image sensor (camera), and three-dimensionally measured with, for example, a laser displacement meter, a phase shifting method, a space-coding method, and a light-section method.

The component inspection apparatus Y2 inspects the arrangement of electronic components on the circuit board fed from the mounter X2. The component inspection apparatus Y2 measures a component placed on the solder paste (which may be the component body or a part of the component such as an electrode, or a lead) in a two-dimensional or three-dimensional manner, and determines whether various inspection items for the component fall within the range of normal values (tolerances) based on the measurement results. The inspection items include a component positional deviation, a component angular (rotational) deviation, a missing component (no component being placed), a component mix-up (a different component being placed), different polarities (the polarity of the component different from the polarity of the circuit board), a reversal (a component being placed upside down), and a component height. In the same manner as in the solder printing inspection, the electronic component is two-dimensionally measured with, for example, an image sensor (camera), and three-dimensionally measured with, for example, a laser displacement meter, a phase shifting method, a space-coding method, and a light-section method.

The appearance inspection apparatus Y3 inspects the state of solder joints on the circuit board fed from the reflow furnace X3. The appearance inspection apparatus Y3 measures the postreflow solder in a two-dimensional or three-dimensional manner, and determines whether various inspection items for the solder joints fall within the range of normal values (tolerances) based on the measurement results. The inspection items include the quality of a solder fillet shape in addition to the items used in the component inspection. The shape of solder is determined with, for example, a laser displacement meter, a phase shifting method, a space-coding method, and a light-section method described above, and also with the color highlight system (a method for detecting the three-dimensional shape of solder with two-dimensional hue information by illuminating the solder surface with RGB color light at different angles of incidence and capturing the reflected light of each color using a top camera).

The X-ray inspection apparatus Y4 inspects the state of solder joints on the circuit board using an X-ray image. For example, a multilayer circuit board and a package component, such as a ball grid array (BGA) and a chip size package (CSP), have solder joints hidden under the circuit board or the component. In this case, the state of the solder cannot be inspected with the appearance inspection apparatus Y3 (or with an appearance image). The X-ray inspection apparatus Y4 overcomes such weakness of an appearance inspection. The inspection items of the X-ray inspection apparatus Y4 include a component positional deviation, a solder height, a solder volume, a solder ball diameter, a back fillet length, and the quality of a solder joint. The X-ray images may be images taken by projecting X-rays, or may be images taken using the computed tomography (CT) scan.

These inspection apparatuses Y1 to Y4 are connected to the inspection management apparatus Y5 via a network (LAN). The inspection management apparatus Y5 is a system responsible for the management and centralized control of the inspection apparatuses Y1 to Y4. The inspection management apparatus Y5 stores, manages, and outputs an inspection program (including an inspection procedure, inspection conditions, and setting parameters) defining the operation of each of the inspection apparatuses Y1 to Y4, the inspection results and log data obtained by the inspection apparatuses Y1 to Y4, and other data.

The analyzer Y6 analyzes the inspection results collected in the inspection management apparatus Y5 from the inspection apparatuses Y1 to Y4 (inspection results from each process) to predict defects, estimate the cause of defects, and may provide the analysis results as feedback to the production facilities X1 to X3 as appropriate (by, for example, changing the mounting program).

The workstation Y7 displays information about, for example, the states of the production facilities X1 to X3, the inspection results from the inspection apparatuses Y1 to Y4, and the analysis results from the analyzer Y6. The workstation Y7 also changes (edits) the mounting program and the inspection program in the production facility management apparatus X4 and the inspection management apparatus Y5. The workstation Y7 also checks the overall operation of the surface mounting line.

The production facility management apparatus X4, the inspection management apparatus Y5, and the analyzer Y6 may all be general-purpose computer systems each including a central processing unit (CPU), a main storage unit (memory), an auxiliary storage unit (e.g., a hard disk), an input device (e.g., a keyboard, a mouse, a controller, and a touch panel), and a display. Although the apparatuses X4, Y5, and Y6 may be separate apparatuses, a single computer system may have all the functions of the apparatuses X4, Y5, and Y6, or a computer included in any one of the production facilities X1 to X3 and the inspection apparatuses Y1 to Y4 may have all or some of the functions of the apparatuses X4, Y5 and Y6. Although Fig. 1 shows the separate networks for the production facilities and for the quality control system, any network allowing mutual data communications may be used.

### Accumulation of Facility State Values

In the present embodiment, to monitor and record the operations of the solder printing apparatus X1, the mounter X2, and the reflow furnace X3, the states of these facilities during operation are observed with a sensor or a measuring device, and the resultant observation values (facility state values) are accumulated in the production facility management apparatus X4. The observation values (facility state values) include physical quantities measured with the sensor as well as values calculated from measurement data obtained by the sensor and feature quantities extracted from the measurement data. The items to be observed by each production facility may be determined freely. For example, the solder printing apparatus X1 has conditions that may affect the quality of solder printing including squeegee pressure, squeegee speed, printing pressure, and the viscosity of solder paste. The mounter X2 has conditions that may affect the quality of electronic component mounting including nozzle adsorption vacuum pressure and the pushed-in amount of the component. Further, the reflow furnace X3 has conditions that may affect the quality of solder joints including preheating temperature, preheating time, melting temperature, melting time, and furnace atmosphere. These items are mere examples, and any other items may be observed. The items observed in the production facility management apparatus X4, the workstation Y7, and the analyzer Y6 may also be selectable by a user by operating these production facilities.

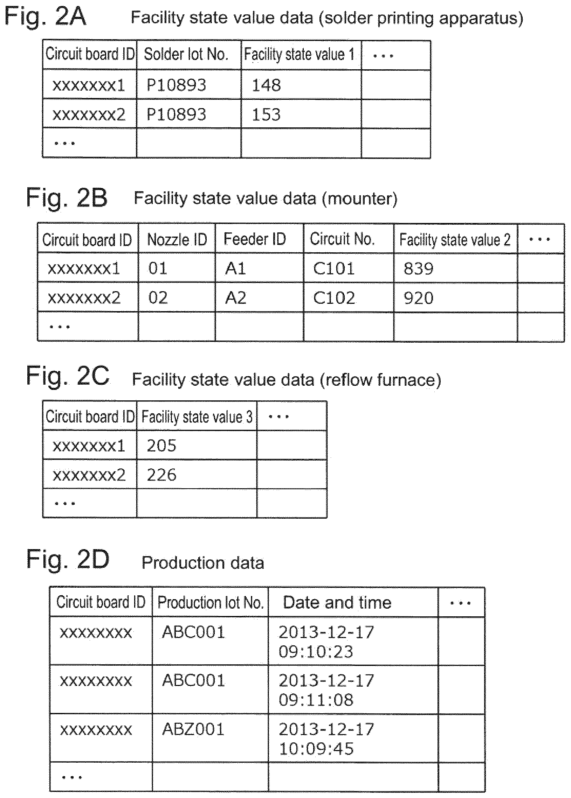

Figs. 2A to 2C show the facility state value data for the solder printing apparatus X1, the mounter X2, and the reflow furnace X3 in one example. The data for the solder printing apparatus X1 includes circuit board IDs for identifying processed circuit boards, lot numbers of the used solder paste, and one or more facility state values observed when the circuit boards are processed, which are associated with one another. The data for the mounter X2 includes circuit board IDs, nozzle IDs for identifying nozzles used to attract components, feeder IDs for identifying feeders used to feed components, circuit numbers for identifying circuit board areas on which the components are mounted, and one or more facility state values observed when the components are mounted, which are associated with one another. The data for the reflow furnace X3 includes circuit board IDs and one or more facility state values observed when the circuit boards are processed, which are associated with each other.

Fig. 2D shows production data recorded in the production facility management apparatus X4 in one example. The production data includes the histories of circuit boards produced in this production line. As shown in the figure, the data includes circuit board IDs, production lot numbers, and date and time information, which are associated with one another. The production data is referred to in the process of generating acceptable article distributions described later to extract the facility state value data for a predetermined period of time or to delete old facility state value data. The facility state value data shown in Figs. 2A to 2C may include date and time information or production lot numbers to eliminate the production data.

### Accumulation of Product State Values

In the present embodiment, to monitor and record the quality of solder as a final product, the states (shapes) of solder pieces formed on lands are measured with a sensor or a detector, and the resultant measurement values (product state values) are accumulated in the inspection management apparatus Y5. The measurement values (product state values) include physical quantities measured with the sensor as well as values calculated from measurement data obtained by the sensor and feature quantities extracted from the measurement data.

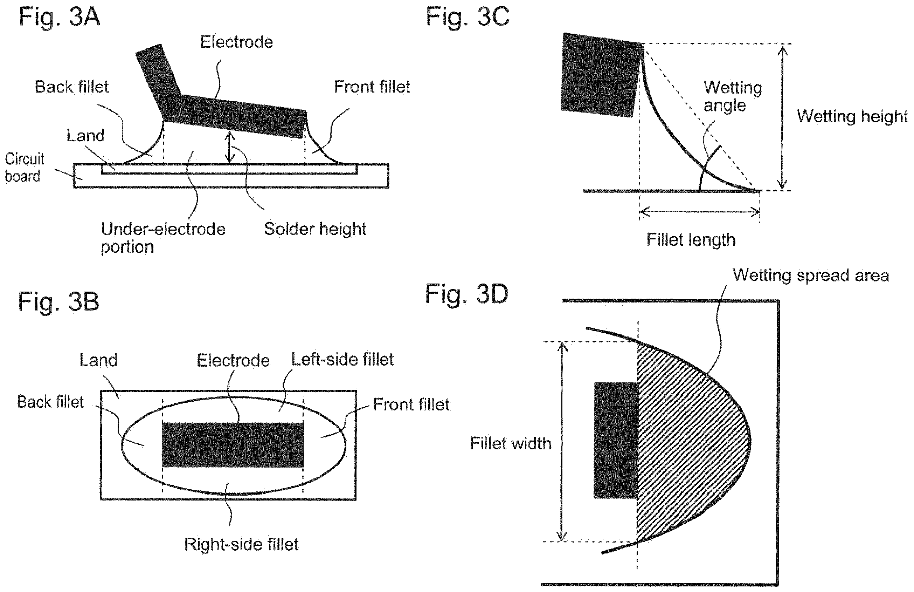

Figs. 3A to 3D show the names of solder portions and product state values indicating the shape of the solder in one example. Fig. 3A is a side view of the solder as viewed in the direction parallel to the circuit board. Fig. 3B is a top plan view of the solder as viewed from above the circuit board. Fig. 3C is an enlarged partial view of Fig. 3A, and Fig. 3D is an enlarged partial view of Fig. 3B. For ease of explanation, the component body and other part are not shown.

In the present embodiment, the entire solder is divided into five portions: a front fillet, a back fillet, a right-side fillet, a left-side fillet, and an under-electrode portion. The front fillet is a solder fillet portion adjacent to the front end of the component electrode. The back fillet is a solder fillet portion adjacent to the rear end of the component electrode. The right-side fillet is a solder fillet portion adjacent to the right side of the component electrode as viewed from the rear end of the component electrode. The left-side fillet is a solder fillet portion adjacent to the left side of the component electrode as viewed from the rear end of the component electrode. The under-electrode portion is a solder portion under the electrode.

As shown in Figs. 3C and 3D, the shape of each solder fillet portion is defined by five product state values: a wetting angle, a wetting spread area, a wetting height, a fillet length, and a fillet width. The wetting angle is an angle of inclination of a fillet, which is an angle formed between the land and the line connecting the top and the end point of the fillet in the present embodiment. The wetting spread area is the area of contact between the solder and the land (the shaded area in Fig. 3D). The wetting height is the height from the land to the top of the fillet. The fillet length and the fillet width are the maximum length and the maximum width of the contact area between the solder and the land. The longitudinal direction is parallel to the line connecting the top and the end point of the fillet, whereas the width direction is orthogonal to the longitudinal direction. The under-electrode portion has one product state value of the solder height as shown in Fig. 3A. The solder height is the thickness of the solder at the center of the under-electrode portion.

These product state values can be determined based on the shape measurement results from the appearance inspection apparatus Y3 and from the X-ray inspection apparatus Y4. These state values may be calculated using any algorithm. For example, a solder fillet can be cut out by extracting an RGB-hue portion from an appearance image obtained by the color highlight system to determine the wetting spread area, the fillet length, and the fillet width. Additionally, the wetting height can be measured with a laser displacement meter or a phase shifting method to calculate the wetting angle.

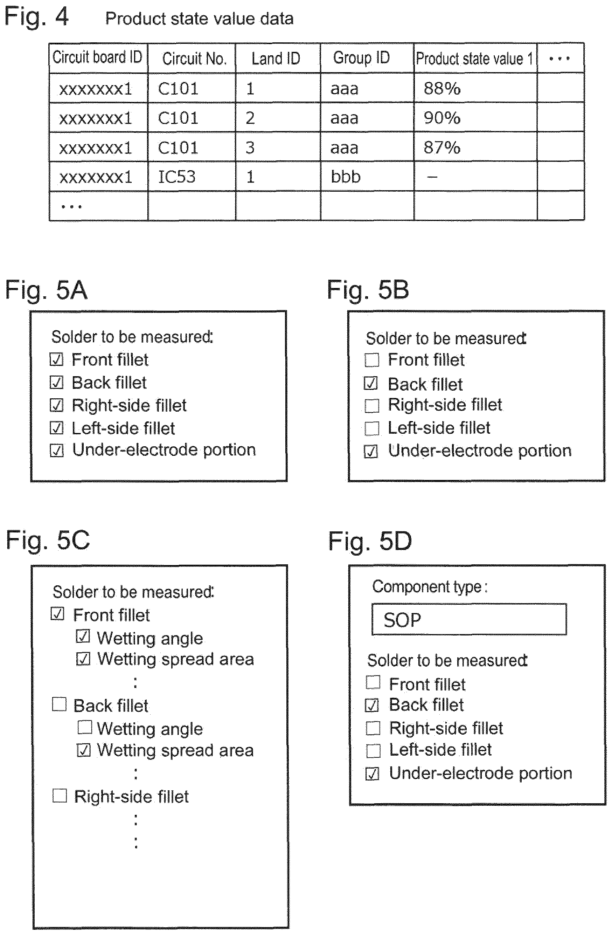

Fig. 4 shows product state value data recorded in the inspection management apparatus Y5 in one example. The product state value data includes circuit board IDs, circuit numbers, land IDs, group IDs, and one or more product state values associated with one another. Each row of the product state value data indicates information obtained from one solder piece (or one land). The land IDs are information for identifying the land positions in a circuit. For example, the land IDs for a component with eight electrodes can have the values of 1 to 8. The group IDs are information indicating a group of lands with the same shape, electrodes with the same shape, and the solder pieces to have the same shape (for which the product state values can be managed and evaluated using the same criteria). For example, a group ID is assigned to a component product number. When a plurality of components with the same product number are mounted on a circuit board, lands to which the same group ID is assigned each have a common group ID. When a single component has electrodes and lands with different shapes, and lands on which solder pieces with different shapes may be formed (e.g., the end pins and other pins of a quad flat package, or QFP), one group ID may be assigned to lands on which solder pieces with the same shapes are formed.

The shape of the resultant solder varies depending on the type of the component and the design of the land. When, for example, the pitch between electrodes is small and the land width is also small, almost no side fillets are formed. When the land length is small, a very small front fillet may be formed. The inspection management apparatus Y5, the analyzer Y6, and the workstation Y7 may allow the user to select the solder shapes for measurements (product state values) for each component type or each land design. Figs. 5A to 5D show example user interfaces for selecting targets to be measured. Fig. 5A shows an example for a standard land size, in which the product state values of all the five portions, namely, the front fillet, the back fillet, the right-side fillet, the left-side fillet, and the under-electrode portion, are selected to be measured. Fig. 5B shows an example for a short land, in which the product state values of two portions, the back fillet and the under-electrode portion, are selected to be measured. Fig. 5C shows an example of a user interface that allows individual product state values to be measured selectively. Fig. 5D shows an example in which appropriate portions are automatically set for measurements in response to a selection of the component type from a pull-down menu. Limiting the product state values to be measured in accordance with the component type and the land design in this manner can shorten the time taken to measure and calculate the product state values. Although these product state values are used to detect abnormalities in an abnormality detection process described later, appropriately set items for evaluation in accordance with the component type and the land design can avoid excessive quality control and abnormality detection (abnormality detection will be described in detail later).

### Evaluating Solder Joints

An article is determined acceptable or unacceptable by the appearance inspection apparatus Y3 typically based on whether it has a sufficient amount of front fillet, because the shape of an electrode undersurface and the shape of a back fillet are not directly observable by the appearance inspection apparatus Y3. However, not only the front fillet but also a joint between the electrode undersurface and the solder and the back fillet can greatly contribute to the joining strength between the solder and the component electrode. Thus, using the result from an appearance inspection alone can cause excessive checks.

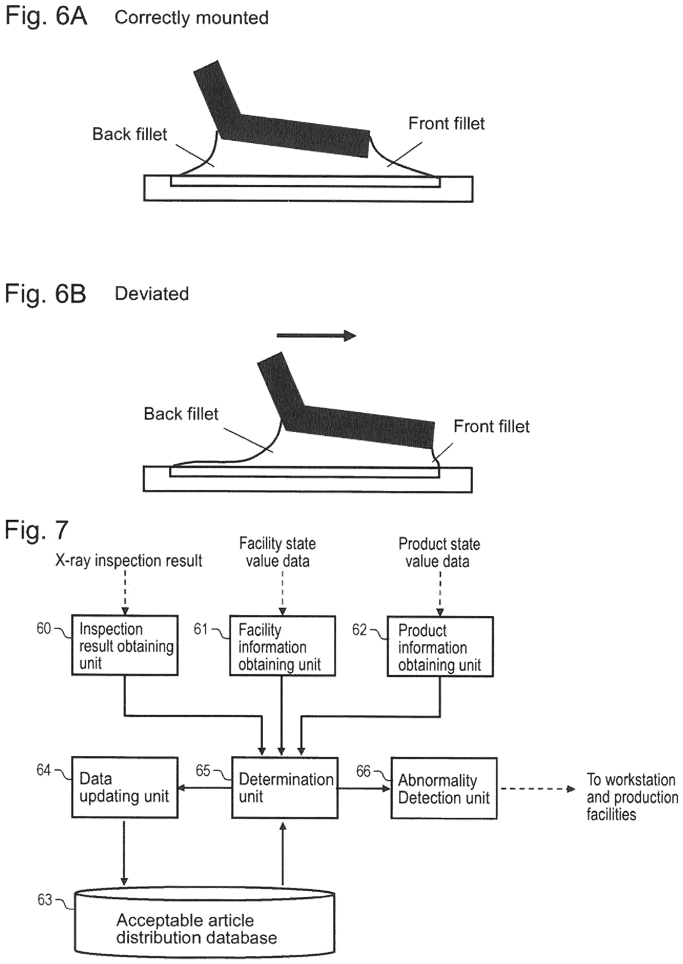

Figs. 6A and 6B show such examples. Fig. 6A shows the shape of solder with a component mounted at the correct position. Fig. 6B shows the shape of solder with a component mounted at a position deviated toward the front end of the electrode. The article shown in Fig. 6A has a sufficient amount of front fillet, and thus passes an appearance inspection and yields a correct inspection result. If the component deviates toward the front end of the electrode, a small front fillet forms as shown in Fig. 6B. Although the joining strength is achieved by a sufficient amount of back fillet in this case (or the state of the solder joint is acceptable), the article fails an appearance inspection. The circuit board is determined defective and can be discarded, or the production line can be stopped unnecessarily after an abnormality is erroneously detected in the production facilities. Such excessive checks lower the efficiency.

To correctly determine the quality of solder in the example shown in Fig. 6B, the quality of solder is finally determined based on an inspection result from the X-ray inspection apparatus Y4 in the present embodiment. The difference between the X-ray absorptivity of an electrode and the absorptivity of solder causes a luminance difference between an electrode portion and a solder portion in an X-ray image (X-ray transmission image or a tomogram). Analyzing the X-ray image thus allows examination of the electrode undersurface for a joint between the electrode and the solder, and also allows measurement of the area of the joint (corresponding to the joining strength) between the electrode and the solder.

### Abnormality Detection Process

The abnormality detection process performed by the analyzer Y6 will now be described. In the abnormality detection process, the quality of solder joints is constantly monitored during operation of the production line to detect abnormalities in the production facilities X1 to X3, and feedback is provided to the operating conditions of the facilities as appropriate.

Fig. 7 is a diagram showing functional blocks associated with the abnormality detection process performed by the analyzer Y6. The analyzer Y6 has the functions of an inspection result obtaining unit 60, a facility information obtaining unit 61, a product information obtaining unit 62, an acceptable article distribution database 63, a data updating unit 64, a determination unit 65, and an abnormality detection unit 66. These functions are achieved by the analyzer Y6 (CPU) executing a computer program. Fig. 7 shows the functions of the analyzer Y6 associated with the abnormality detection process, and does not show the other functions.

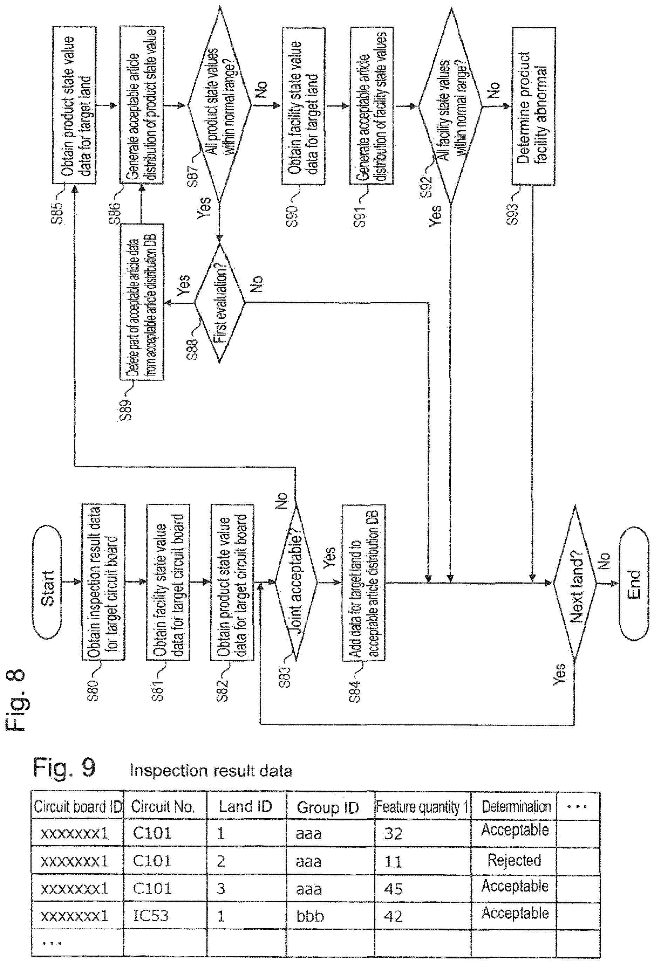

The abnormality detection process and the detailed processing performed by each functional block will now be described with reference to the flowchart in Fig. 8. The processing in Fig. 8 is triggered by inspection results obtained for one circuit board from the X-ray inspection apparatus Y4.

The inspection result obtaining unit 60 first obtains data about inspection results from the X-ray inspection apparatus Y4 (or via the inspection management apparatus Y5) (step S80). As shown in Fig. 9, the data about the inspection results includes the circuit board ID, the circuit number, the land ID, the group ID, the feature quantity value indicating the states of solder joints, and the determination result of the feature quantity value. Examples of the feature quantity indicating the state of each solder joint include the area of the joint between an electrode and the solder, the luminance difference between an electrode portion and its surrounding in an X-ray image, and the length, the width, and the area of a back fillet. A single set or multiple sets of determination results and feature quantities indicating the states of joints for one item or multiple items may be used. Hereafter, the circuit board for which inspection results have been obtained (the circuit board identified by the circuit board ID) is referred to as a target circuit board.

The facility information obtaining unit 61 obtains the facility state value data for the target circuit board from the production facility management apparatus X4 based on the circuit board ID (step S81). The details of the facility state value data are shown in Figs. 2A to 2C. The product information obtaining unit 62 obtains the product state value data for the target circuit board from the inspection management apparatus Y5 based on the circuit board ID (step S82). The details of the product state value data are shown in Fig. 4.

The processing from steps S80 to S82 yields the final inspection result data indicating the states of solder joints for the target circuit board, the facility state value data for each production facility processing the circuit board, and the product state value data for the solder formed on each land. Subsequently, the processing in step S83 and subsequent steps is performed for each individual land (solder piece) on the target circuit board. Hereafter, the land to be processed is referred to as a target land.

In step S83, the determination unit 65 refers to the inspection results for the target land to check whether all feature quantities indicating the state of the joint have passed the inspection. When all the inspection items have passed the inspection (step S83: Yes), the determination unit 65 determines that the target land is an acceptable article. The data updating unit 64 adds the product state value data (refer to Fig. 4) and the facility state value data (refer to Figs. 2A to 2C) for the solder on the target land to the acceptable article distribution database 63 (step S84).

The acceptable article distribution database 63 is a storage for accumulating data groups of the product state values and the facility state values of a plurality of acceptable articles produced in the past. The data groups accumulated in the database are used to evaluate the distributions of product state values and facility state values of acceptable articles. In the initial state (e.g., at the start of mass production trial), the acceptable article distribution database 63 contains no data. As the production line is operated and the acceptable article distribution database 63 accumulates data, the distribution of acceptable articles has higher reliability. The data that is too old or the data for the previous production lot may be inappropriate for evaluating the acceptable article distribution. The data updating unit 64 may delete the past data either regularly or when the production lot changes.

When at least one of the feature quantities indicating the state of the joint on the target land has failed the inspection in step S83, the determination unit 65 determines that the target land is a defective article, and advances the processing to step S85. The processing of step S85 and subsequent steps refers to the distributions of product state values and facility state values of acceptable articles. When the acceptable article distribution database 63 contains no data or contains an insufficient amount of accumulated data, the determination unit 65 may skip the processing in step S85 and subsequent steps, and may stop the abnormality detection process. In the example described below, the acceptable article distribution database 63 stores a sufficient amount of accumulated data.

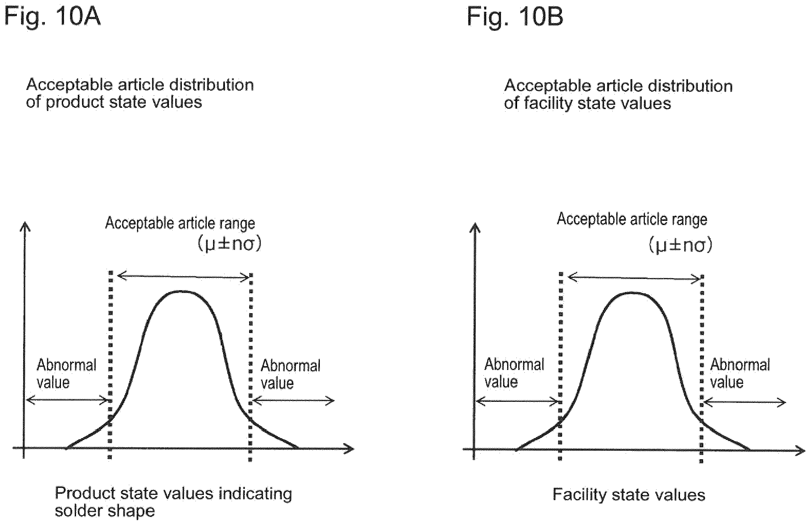

In step S85, the determination unit 65 obtains the product state value data for the solder of the target land (defective article). The determination unit 65 reads the product state value data for acceptable articles having the same group ID as the group ID of the target land from the acceptable article distribution database 63, and generates an acceptable article distribution of product state values (step S86). When the product state value data includes multiple items of product state values, the determination unit 65 generates an acceptable article distribution for each item of product state values. Fig. 10A is a graph showing the distribution of product state values of acceptable articles. In the present embodiment, the average µ and the standard deviation σ of the product state values of acceptable articles are calculated, and variations in the product state values of the acceptable articles are approximated using a normal distribution. In some embodiments, the acceptable article distribution may be generated using a histogram (frequency distribution).

Subsequently, the determination unit 65 compares the product state value of the target land (defective article) with the product state values of the acceptable article distribution to determine whether the value of the target land (defective article) is within a normal range (acceptable article range) or the value of the target land is an abnormal value (step S87). The normal range can be set to, for example, µ ± nσ of the acceptable article distribution. The value n can be set by a user in accordance with the quality requirements. The value n may be set to, for example, 2 to 5 (typically to 3 to 4).

When all the product state values of the target land (defective article) are determined to be within the normal range (acceptable article range) in step S87, the data updating unit 64 updates the acceptable article distribution (by learning) (step S89). Through this updating process, the acceptable article distribution is corrected to increase the likelihood of the product state value of the target land (defective article) being determined to be an abnormal value. The updating process specifically includes deleting one sample data set about acceptable articles having the same value as the product state value of the target land (or a data set with the closest value if no data set with the same value is found) from the data groups of acceptable articles accumulated in the acceptable article distribution database 63. This lowers the probability of determining the product state value of the target land to be within the normal range. In some embodiments, the acceptable article distribution may be updated in a different manner. For example, n sample sets (n > 1) of acceptable article data having the value closest to the product state value of the target land may be deleted. As exceptional processing, the acceptable article distribution may not be updated when the product state value of the target land is close to the average µ of the acceptable article distribution (e.g., µ ± 2σ or lower).

When the acceptable article distribution is updated in step S89, the determination unit 65 repeats the processing in step S87 to compare the product state value of the target land (defective article) with the updated acceptable article distribution. When all the product state values of the target land are determined to be within the normal range in comparison with the updated acceptable article distribution, the determination unit 65 determines that the production facilities have no abnormalities (that is, the defect in the target land is an unusual event or an event with an unknown cause), and ends the abnormality detection process. For the second evaluation (step S88), the acceptable article distribution is not updated.

When determining that at least one of the product state values of the target land (defective article) is an abnormal value in step S87, the determination unit 65 determines that at least one of the production facilities may have an abnormality, and advances the processing to step S90. In step S90, the determination unit 65 obtains the facility state value data for the solder of the target land (defective article). The determination unit 65 reads the facility state value data corresponding to each of the multiple acceptable articles used to create the acceptable article distribution of the product state values from the acceptable article distribution database 63, and generates an acceptable article distribution of facility state values (step S91). When the facility state value data includes multiple items of facility state values, the determination unit 65 generates an acceptable article distribution for each facility state value. Fig. 10B is a graph showing the distribution of facility state values of acceptable articles. In the present embodiment, the average µ and the standard deviation σ of the facility state values of acceptable articles are calculated, and variations in the facility state values of the acceptable articles are approximated using a normal distribution in the same manner as for the acceptable article distribution of the product state values. In some embodiments, the acceptable article distribution may be generated using a histogram (frequency distribution).

Subsequently, the determination unit 65 compares the facility state value of the target land (defective article) with the facility state values of the acceptable article distribution to determine whether the value of the target land (defective article) is within a normal range (acceptable article range) or the value of the target land is an abnormal value (step S92). The normal range can be set to, for example, µ ± nσ of the acceptable article distribution. The value n can be set by a user in accordance with the quality requirements or facility performance. The value n may be set to, for example, 2 to 5 (typically 3 or 4). The product state value and the facility state value may have different normal ranges (values of n).

When all the facility state values of the target land (defective article) are determined to be within the normal range (acceptable article range) in step S92, the determination unit 65 determines that the production facilities have no abnormalities (step S92: Yes), and ends the abnormality detection process.

When determining that at least one of the facility state values of the target land (defective article) is an abnormal value in step S92, the abnormality detection unit 66 determines that at least one of the production facilities may have an abnormality, and implements necessary measures (step S93). To notify the user of the abnormality, for example, the abnormality detection unit 66 may output information identifying the production facility with the suspected abnormality (e.g., the facility name), the facility state value indicating the abnormality, and information about possible measures (e.g., changing the operating conditions, repairing, and resetting) to the analyzer, the workstation, and the relevant production facility. Other output information may include information about the defective article (information identifying the target circuit board and the target land, the feature quantity indicating the state of the joint that has failed the inspection, and the feature quantity value), and information about the product state value indicating the abnormality, and the acceptable article distributions of the facility state values and the product state values. The information may be output with any method including displaying on a monitor, printing with a printer, outputting sound from a speaker, and sending email. In some embodiments, the abnormality detection unit 66 may also determine changes in the operating conditions of the production facility to remove the abnormality, and may change the operating conditions (for example, a mounting program) of the relevant production facility. The abnormality detection unit 66 may automatically change the operating conditions of the production facility, or may ask the user for permission to change the operating conditions by displaying, for example, a prompt to "change operating conditions?" on the monitor of the analyzer, the workstation, or the production facility, and may change the operating conditions after receiving the user permission.

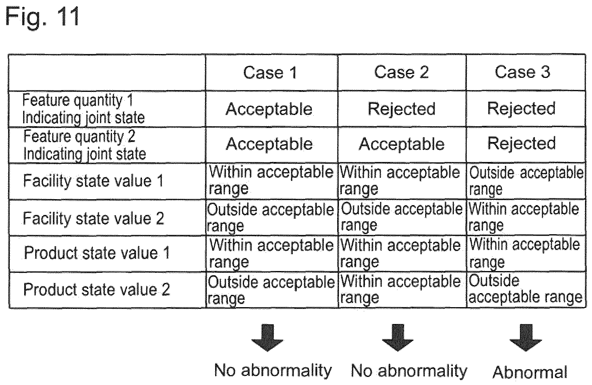

When the processing described above is performed for all lands, the abnormality detection process in Fig. 8 is completed. Fig. 11 is a diagram describing specific example cases of the abnormality detection process in Fig. 8. These examples use two items of facility state values, two items of product state values, and two items of feature quantities indicating the state of a joint.

(1) In case 1, all the feature quantities indicating the state of the joint pass the inspection. In this case, the target land is determined to be an acceptable article, and the facility state value data and the product state value data for the target land are added to the data groups of the acceptable article distribution (step S83: Yes, advancing the processing to step S84). In case 1, no facility state values and no product state values of the target land are evaluated. Even when the facility state values and the product state values include an abnormal value (outside the acceptable article range) as in Figs. 10A and 10B, the feature quantities indicating the state of the joint (final quality determination of the solder shape) are used with priority.

(2) In case 2, at least one of the feature quantities indicating the state of the joint fails the inspection, whereas all the product state values of the target land fall within the acceptable article range. In this case, the production facilities are determined to have no abnormalities (although the target land is a defective article), and no feedback is provided to the production facilities (step S87: Yes).

(3) In case 3, at least one of the feature quantities indicating the state of the joint fails the inspection, and the product state values of the target land include an abnormal value (a value outside the acceptable article range). In this case, the facility state values of the production facilities are evaluated. If the facility state values include an abnormal value (a value outside the acceptable article range), the production facilities are determined to have an abnormality.

### Advantages of Present Embodiment

The structure according to the above embodiment determines that a production facility has an abnormality when the state of a solder joint is determined defective, the state of the solder shape of the defective article (product state value) is determined abnormal in comparison with the acceptable article distribution, and the state of the production facility that has processed the defective article (facility state value) is determined abnormal in comparison with the acceptable article distribution. The determination result is provided as feedback to the user or the production facility. This structure detects a state that can affect the final quality of the product and has its product state and production facility state both deviating from normal states. This reduces erroneous reports of abnormalities of the production facilities (excessive quality control). In the present embodiment, the X-ray inspection accurately detects the state of a joint between solder and an electrode that cannot be identified by appearance. This can minimize erroneous determination to be an acceptable article or a defective article, and reduce excessive quality control. Moreover, the product state values used for determination can be selected (limited) in accordance with the type of a component and the specifications of a land. This increases the speed of processing and reduces excessive quality control. Further, the acceptable article distribution is automatically updated (by learning) using information about an acceptable article and a defective article obtained during actual operation of the production line. This increases the reliability of the acceptable article distribution and thus enhances the validity and the accuracy of the abnormality determination.

### Other Embodiments

The above embodiment is illustrative only and is not intended to be limiting.

For example, although the quality of the state of a solder joint is determined with an X-ray inspection in the above embodiment, other inspection techniques may also be used. Examples of such techniques include an appearance inspection apparatus, a nondestructive inspection apparatus with ultrasound, and an apparatus for inspecting the state of a joint with a continuity test. In some embodiments, an operator may visually inspect a joint and input the inspection result into an inspection management apparatus.

Although the above embodiment describes the surface mounting line, the present invention may be applicable to the quality control of any other production line that includes one or more production facilities.

In the above embodiment, the entire solder is divided into five portions as shown in Figs. 3A to 3D. This method is a mere example and may be modified. For example, the solder may be divided into three portions: a front fillet, a back fillet, and an under-electrode portion. In the above embodiment, five product state values, namely, the wetting angle, the wetting spread area, the wetting height, the fillet length, and the fillet width are measured for the solder fillets, whereas one product state value, the solder height, is measured for the under-electrode portion. However, this is a mere example, and other product state values may be used. The wetting angle may be, for example, the wetting angle adjacent to a land and the wetting angle adjacent to an electrode. The fillet width may be, for example, the width of the front end of an electrode and the width of the front end of a land.

### REFERENCE SIGNS LIST

- 60: inspection result obtaining unit
- 61: facility information obtaining unit
- 62: product information obtaining unit
- 63: acceptable article distribution database
- 64: data updating unit
- 65: determination unit
- 66: abnormality detection unit
- X1: solder printing apparatus
- X2: mounter
- X3: reflow furnace
- X4: production facility management apparatus
- Y1: solder printing inspection apparatus
- Y2: component inspection apparatus
- Y3: appearance inspection apparatus
- Y4: X-ray inspection apparatus
- Y5: inspection management apparatus
- Y6: analyzer
- Y7: workstation

## Claims

1. A quality control apparatus for quality control of a production line including one or more production facilities, the quality control apparatus comprising:
a facility information obtaining unit (61) configured to obtain data about a facility state value indicating a state of a production facility observed when the production facility processes a product;
a product information obtaining unit (62) configured to obtain data about a product state value indicating a state of the product measured from the product processed by the production facility;
a storage unit (63) configured to store a data group of facility state values of a plurality of acceptable articles produced previously and a data group of product state values of the plurality of acceptable articles;
a determination unit (65) configured to determine, for a product determined to be a defective article, whether a product state value of the defective article is an abnormal value by comparing the product state value with an acceptable article distribution of product state values including the data group of product state values of the plurality of acceptable articles accumulated in the storage unit (63), and determine whether a facility state value observed when the defective article is processed is an abnormal value by comparing the facility state value with an acceptable article distribution of facility state values including the data group of facility state values of the plurality of acceptable articles accumulated in the storage unit (63); and
an abnormality detection unit (66) configured to determine that the production facility has an abnormality when the product state value and the facility state value of the defective article are both determined to be abnormal values;
**characterized in that**
the quality control apparatus further comprising
an update unit configured to add, for a product determined to be an acceptable article, a product state value of the product to the data group of product state values accumulated in the storage unit (63);
wherein
when the abnormality detection unit (66) determines that the production facility has an abnormality, the abnormality detection unit (66) outputs abnormality information, automatically changes an operating condition of the production facility, or changes the operating condition of the production facility after receiving permission to change the operating condition of the production facility from a user; and
wherein
the abnormality information includes at least any of information identifying the production facility determined to have an abnormality, the facility state value determined to be an abnormal value, information identifying the product determined to be a defective article, or the product state value determined to be an abnormal value.

2. The quality control apparatus according to claim 1, wherein
when the determination unit (65) determines, for a product determined to be a defective article, that a product state value of the defective article is not an abnormal value, the update unit deletes a part of the data group of product state values stored in the storage unit (63) to increase a likelihood of the product state value of the defective article being determined to be an abnormal value.

3. The quality control apparatus according to any one of claims 1 to 2, wherein
the determination unit (65) is configured to determine whether a plurality of items of product state values measured from one product are abnormal values, and
the determination unit (65) is configured to select an item to be used for determination from the plurality of items.

4. The quality control apparatus according to any one of claims 1 to 3, wherein
the production line is a surface mounting line for a printed circuit board,
the production facility includes at least one of a solder printing apparatus (X1) configured to print solder paste on the printed circuit board, a mounter (X2) configured to mount an electronic component onto the printed circuit board, or a reflow furnace (X3) configured to heat the solder paste, and
a state of the product is a shape of postreflow solder.

5. The quality control apparatus according to claim 4, wherein
a determination result indicating whether solder is an acceptable article or a defective article is obtained from an X-ray inspection apparatus (Y4) configured to inspect a state of a joint between the solder and an electrode of the electronic component with an X-ray image.

6. A method for controlling a quality control apparatus for quality control of a production line including one or more production facilities, the method comprising:
obtaining data about a facility state value indicating a state of a production facility observed when the production facility processes a product;
obtaining data about a product state value indicating a state of the product measured from the product processed by the production facility;
determining, for a product determined to be a defective article, whether a product state value of the defective article is an abnormal value by comparing the product state value with an acceptable article distribution of product state values including the data group of product state values of the plurality of acceptable articles;
determining whether a facility state value observed when the defective article is processed is an abnormal value by comparing the facility state value with an acceptable article distribution of facility state values including the data group of facility state values of the plurality of acceptable articles; and
determining that the production facility has an abnormality when the product state value and the facility state value of the defective article are both determined to be abnormal values;
**characterized by** the steps of
adding, for a product determined to be an acceptable article, a product state value of the product to the data group of product state values;
outputting abnormality information, automatically changing an operating condition of the production facility, or changing the operating condition of the production facility after receiving permission to change the operating condition of the production facility from a user, when it is determined that the production facility has an abnormality; and
wherein the abnormality information includes at least any of information identifying the production facility determined to have an abnormality, the facility state value determined to be an abnormal value, information identifying the product determined to be a defective article, or the product state value determined to be an abnormal value.

7. A program enabling a computer to implement the steps included in the method for controlling the quality control apparatus according to claim 6.

## Patentansprüche

1. Qualitätskontrollvorrichtung zur Qualitätskontrolle einer Produktionslinie, die eine oder mehrere Produktionsanlagen beinhaltet, wobei die Qualitätskontrollvorrichtung umfasst:
eine Anlageninformationserhalteinheit (61), die konfiguriert ist, Daten über einen Anlagenzustandswert zu erhalten, der einen Zustand einer Produktionsanlage angibt, der beobachtet wird, wenn die Produktionsanlage ein Produkt verarbeitet;
eine Produktinformationserhalteinheit (62), die konfiguriert ist, Daten über einen Produktzustandswert zu erhalten, der einen Zustand des Produkts angibt, der von dem Produkt gemessen wird, das von der Produktionsanlage verarbeitet wird;
eine Speichereinheit (63), die konfiguriert ist, eine Datengruppe von Anlagenzustandswerten einer Vielzahl von akzeptablen Artikeln zu speichern, die zuvor produziert wurden, und eine Datengruppe von Produktzustandswerten der Vielzahl von akzeptablen Artikeln;
eine Bestimmungseinheit (65), die konfiguriert ist, für ein Produkt, das als ein defekter Artikel bestimmt wird, zu bestimmen, ob ein Produktzustandswert des defekten Artikels ein anomaler Wert ist, indem sie den Produktzustandswert mit einer akzeptablen Artikelverteilung der Produktzustandswerte, die die Datengruppe von Produktzustandswerten der Vielzahl akzeptabler Artikel, die in der Speichereinheit (63) akkumuliert wurden, vergleicht, und bestimmt, ob ein Anlagenzustandswert, der beobachtet wird, wenn der defekte Artikel verarbeitet wird, ein anomaler Wert ist, durch Vergleichen des Anlagenzustandswerts mit einer akzeptablen Artikelverteilung der Anlagenzustandswerte, die die Datengruppe von Anlagenzustandswerten der Vielzahl akzeptabler Artikel, die in der Speichereinheit (63) akkumuliert wurden, beinhalten; und
eine Anomalieerkennungseinheit (66), die konfiguriert ist zu bestimmen, dass die Produktionsanlage eine Anomalie aufweist, wenn der Produktzustandswert und der Anlagenzustandswert des defekten Artikels beide als anomale Werte bestimmt werden;
**dadurch gekennzeichnet, dass**
die Qualitätskontrollvorrichtung ferner umfasst
eine Aktualisierungseinheit, die konfiguriert ist, für ein Produkt, das als ein akzeptabler Artikel bestimmt wurde, einen Produktzustandswert des Produkts der Datengruppe von Produktzustandswerten, die in der Speichereinheit (63) akkumuliert wurden, hinzuzufügen;
wobei
wenn die Anomalieerkennungseinheit (66) bestimmt, dass die Produktionsanlage eine Anomalie aufweist, die Anomalieerkennungseinheit (66) Anomalieinformationen ausgibt, eine Betriebsbedingung der Produktionsanlage automatisch ändert oder die Betriebsbedingung der Produktionseinrichtung nach Erhalten einer Erlaubnis von einem Benutzer, die Betriebsbedingung der Produktionsanlage zu ändern; und
wobei
die Anomalieinformationen mindestens jedwedes beinhaltet von Informationen, die die Produktionsanlage identifizieren, bei der eine Anomalie bestimmt wurde, dem Anlagenzustandswert, der als ein anomaler Wert bestimmt wurde, Informationen, die das Produkt identifizieren, das als ein defekter Artikel bestimmt wurde, oder den Produktzustandswert, der als ein anomaler Wert bestimmt wurde.

2. Qualitätskontrollvorrichtung nach Anspruch 1, wobei
wenn die Bestimmungseinheit (65), für ein Produkt, das als ein defekter Artikel bestimmt wurde, bestimmt, dass ein Produktzustandswert des defekten Artikels kein anomaler Wert ist, die Aktualisierungseinheit einen Teil der Datengruppe der Produktzustandswerte, die in der Speichereinheit (63) gespeichert sind, löscht, um eine Wahrscheinlichkeit zu erhöhen, dass der Produktzustandswert des defekten Artikels als ein anomaler Wert bestimmt wird.

3. Qualitätskontrollvorrichtung nach einem der Ansprüche 1 bis 2,
wobei
die Bestimmungseinheit (65) konfiguriert ist zu bestimmen, ob eine Vielzahl von Elementen der Produktzustandswerte von einem Produkt anomale Werte sind, und
die Bestimmungseinheit (65) konfiguriert ist, ein Element, das für Bestimmung verwendet wird, aus der Vielzahl von Elementen auszuwählen.

4. Qualitätskontrollvorrichtung nach einem der Ansprüche 1 bis 3,
wobei
die Produktionslinie eine Flächenmontagelinie für eine Leiterplatte ist,
die Produktionsanlage eine Lötdruckvorrichtung (X1), die für Drucken von Lötpaste auf die Leiterplatte konfiguriert ist, eine Montagevorrichtung (X2), die für Montieren einer elektronischen Komponente auf die Leiterplatte konfiguriert ist, und/oder einen Reflow-Ofen (X3), der für Erwärmen der Lötpaste konfiguriert ist, beinhaltet, und
ein Zustand des Produkts eine Form des Post-Reflow-Lots ist.

5. Qualitätskontrollvorrichtung nach Anspruch 4, wobei
ein Bestimmungsergebnis, das angibt, ob Lot ein akzeptabler Artikel oder ein defekter Artikel ist, von einer Röntgenprüfvorrichtung (Y4) erhalten wird, die konfiguriert ist, einen Zustand einer Verbindung zwischen dem Lot und einer Elektrode der elektronischen Komponente mit einem Röntgenbild zu prüfen.

6. Verfahren zum Steuern einer Qualitätskontrollvorrichtung für Qualitätskontrolle einer Produktionslinie, die eine oder mehrere Produktionsanlagen beinhaltet, wobei das Verfahren umfasst:
Erhalten von Daten über einen Anlagenzustandswert, der einen Zustand einer Produktionsanlage angibt, der beobachtet wird, wenn die Produktionsanlage ein Produkt verarbeitet;
Erhalten von Daten über einen Produktzustandswert, der einen Zustand des Produkts angibt, der von dem Produkt gemessen wird, das von der Produktionsanlage verarbeitet wird;
Bestimmen, für ein Produkt, das als ein defekter Artikel bestimmt wird, ob ein Produktzustandswert des defekten Artikels ein anomaler Wert ist, durch Vergleichen des Produktzustandswerts mit einer akzeptablen Artikelverteilung der Produktzustandswerte, die die Datengruppe der Produktzustandswerte der Vielzahl von akzeptablen Artikeln beinhalten;
Bestimmen, ob ein Anlagenzustandswert, der beobachtet wird, wenn der defekte Artikel verarbeitet wird, ein anomaler Wert ist, durch Vergleichen des Anlagenzustandswerts mit einer akzeptablen Artikelverteilung der Anlagenzustandswerte, die die Datengruppe der Anlagenzustandswerte der Vielzahl von akzeptablen Artikeln beinhaltet; und
Bestimmen, dass die Produktionsanlage eine Anomalie aufweist, wenn der Produktzustandswert und der Anlagenzustandswert des defekten Artikels beide als anomale Werte bestimmt werden;
**gekennzeichnet durch** die Schritte
Hinzufügen, für ein Produkt, das als ein akzeptabler Artikel bestimmt wurde, eines Produktzustandswerts des Produkts zu der Gruppe von Produktzustandswerten;
Ausgeben von Anomalieinformationen, automatisches Ändern einer Betriebsbedingung der Produktionsanlage oder Ändern der Betriebsbedingung der Produktionseinrichtung nach Empfangen einer Erlaubnis, die Betriebsbedingung der Produktionsanlage zu ändern, von einem Benutzer, wenn bestimmt wird, dass die Produktionsanlage eine Anomalie aufweist; und
wobei die Anomalieinformationen mindestens jedwedes beinhalten von Informationen, die die Produktionsanlage identifizieren, bei der eine Anomalie bestimmt wurde, dem Anlagenzustandswert, der als ein anomaler Wert identifiziert wurde, Informationen, die das Produkt identifizieren, das als ein defekter Artikel bestimmt wurde, oder den Produktzustandswert, der als ein anomaler Wert bestimmt wurde.

7. Programm, das einen Computer befähigt, die Schritte, die in dem Verfahren zum Steuern der Qualitätskontrollvorrichtung nach Anspruch 6, zu implementieren.

## Revendications

1. Appareil de contrôle de la qualité pour un contrôle de la qualité d'une chaîne de production incluant une ou plusieurs installations de production, l'appareil de contrôle de la qualité comprenant :
une unité d'obtention d'informations d'installation (61) configurée pour obtenir des données sur une valeur d'état d'installation indiquant un état d'une installation de production observé lorsque l'installation de production traite un produit ;
une unité d'obtention d'informations de produit (62) configurée pour obtenir des données sur une valeur d'état de produit indiquant un état du produit mesuré à partir du produit traité par l'installation de production ;
une unité de stockage (63) configurée pour stocker un groupe de données de valeurs d'état d'installation d'une pluralité d'articles acceptables produits précédemment et un groupe de données de valeurs d'état de produit de la pluralité d'articles acceptables ;
une unité de détermination (65) configurée pour déterminer, pour un produit déterminé comme étant un article défectueux, si une valeur d'état de produit de l'article défectueux est une valeur anormale en comparant la valeur d'état de produit avec une distribution de valeurs d'état de produit d'articles acceptables incluant le groupe de données de valeurs d'état de produit de la pluralité d'articles acceptables accumulé dans l'unité de stockage (63), et déterminer si une valeur d'état d'installation observée lorsque l'article défectueux est traité est une valeur anormale en comparant la valeur d'état d'installation avec une distribution de valeurs d'état d'installation d'articles acceptables incluant le groupe de données de valeurs d'état d'installation de la pluralité d'articles acceptables accumulé dans l'unité de stockage (63) ; et
une unité de détection d'anomalie (66) configurée pour déterminer que l'installation de production a une anomalie lorsque la valeur d'état de produit et la valeur d'état d'installation de l'article défectueux sont toutes deux déterminées comme étant des valeurs anormales ;
**caractérisé en ce que**
l'appareil de contrôle de la qualité comprend en outre
une unité de mise à jour configurée pour ajouter, pour un produit déterminé comme étant un article acceptable, une valeur d'état de produit du produit au groupe de données de valeurs d'état de produit accumulé dans l'unité de stockage (63) ;
dans lequel
lorsque l'unité de détection d'anomalie (66) détermine que l'installation de production a une anomalie, l'unité de détection d'anomalie (66) émet des informations d'anomalie, change automatiquement une condition de fonctionnement de l'installation de production, ou change la condition de fonctionnement de l'installation de production après la réception d'une permission pour changer la condition de fonctionnement de l'installation de production provenant d'un utilisateur ; et
dans lequel
les informations d'anomalie incluent au moins l'une quelconque parmi des informations identifiant l'installation de production déterminée comme ayant une anomalie, la valeur d'état d'installation déterminée comme étant une valeur anormale, des informations identifiant le produit déterminé comme étant un article défectueux, ou la valeur d'état de produit déterminée comme étant une valeur anormale.

2. Appareil de contrôle de la qualité selon la revendication 1, dans lequel
lorsque l'unité de détermination (65) détermine, pour un produit déterminé comme étant un article défectueux, qu'une valeur d'état de produit de l'article défectueux n'est pas une valeur anormale, l'unité de mise à jour efface une partie du groupe de données de valeurs d'état de produit stocké dans l'unité de stockage (63) pour augmenter une probabilité que la valeur d'état de produit de l'article défectueux soit déterminée comme étant une valeur anormale.

3. Appareil de contrôle de la qualité selon l'une quelconque des revendications 1 à 2, dans lequel
l'unité de détermination (65) est configurée pour déterminer si une pluralité d'éléments de valeurs d'état de produit mesurées à partir d'un produit sont des valeurs anormales, et
l'unité de détermination (65) est configurée pour sélectionner un élément devant être utilisé pour une détermination à partir de la pluralité d'éléments.

4. Appareil de contrôle de la qualité selon l'une quelconque des revendications 1 à 3, dans lequel
la chaîne de production est une chaîne de montage en surface pour une carte de circuit imprimé,
l'installation de production inclut au moins un parmi un appareil d'impression de brasure (X1) configuré pour imprimer de la pâte à braser sur la carte de circuit imprimé, un monteur (X2) configuré pour monter un composant électronique sur la carte de circuit imprimé, ou un four de fusion (X3) configuré pour chauffer la pâte à braser, et
un état du produit est une forme de brasure post-fusion.

5. Appareil de contrôle de la qualité selon la revendication 4, dans lequel
un résultat de détermination indiquant si une brasure est un article acceptable ou un article défectueux est obtenu à partir d'un appareil d'inspection aux rayons X (Y4) configuré pour inspecter un état d'un raccord entre la brasure et une électrode du composant électronique avec une image aux rayons X.

6. Méthode permettant de commander un appareil de contrôle de la qualité pour un contrôle de la qualité d'une chaîne de production incluant une ou plusieurs installations de production, la méthode comprenant :
l'obtention de données sur une valeur d'état d'installation indiquant un état d'une installation de production observé lorsque l'installation de production traite un produit ;
l'obtention de données sur une valeur d'état de produit indiquant un état du produit mesuré à partir du produit traité par l'installation de production ;
la détermination, pour un produit déterminé comme étant un article défectueux, si une valeur d'état de produit de l'article défectueux est une valeur anormale en comparant la valeur d'état de produit avec une distribution de valeurs d'état de produit d'articles acceptables incluant le groupe de données de valeurs d'état de produit de la pluralité d'articles acceptables ;
le fait de déterminer si une valeur d'état d'installation observée lorsque l'article défectueux est traité est une valeur anormale en comparant la valeur d'état d'installation avec une distribution de valeurs d'état d'installation d'articles acceptables incluant le groupe de données de valeurs d'état d'installation de la pluralité d'articles acceptables ; et
le fait de déterminer que l'installation de production a une anomalie lorsque la valeur d'état de produit et la valeur d'état d'installation de l'article défectueux sont toutes deux déterminées comme étant des valeurs anormales ;
**caractérisée par** les étapes consistant à
ajouter, pour un produit déterminé comme étant un article acceptable, une valeur d'état de produit du produit, au groupe de données de valeurs d'état de produit ;
émettre des informations d'anomalie, changer automatiquement une condition de fonctionnement de l'installation de production, ou changer la condition de fonctionnement de l'installation de production après la réception d'une permission pour changer la condition de fonctionnement de l'installation de production provenant d'un utilisateur, lorsqu'il est déterminé que l'installation de production a une anomalie ; et
dans laquelle les informations d'anomalie incluent au moins l'une quelconque parmi des informations identifiant l'installation de production déterminée comme ayant une anomalie, la valeur d'état d'installation déterminée comme étant une valeur anormale, des informations identifiant le produit déterminé comme étant un article défectueux, ou la valeur d'état de produit déterminée comme étant une valeur anormale.

7. Programme permettant à un ordinateur de mettre en œuvre les étapes incluses dans la méthode permettant de commander l'appareil de contrôle de la qualité selon la revendication 6.
